# EUROPÄISCHE PATENTSCHRIFT

(11) **EP 4 338 289 B1**
(45) Veröffentlichungstag und Bekanntmachung des Hinweises auf die Patenterteilung: **18.03.2026**
(21) Anmeldenummer: 22725214.5
(22) Anmeldetag: 25.04.2022
(51) Int. Cl.: H03K 17/687, H03K 17/18, H03K 17/12, G01R 15/04, G01R 31/327

(54) **ÜBERWACHUNGSANORDNUNG FÜR EINE ELEKTRISCHE KOMPONENTE, HALBLEITERSCHALTERANORDNUNG MIT ÜBERWACHUNGSFUNKTION UND ENERGIESYSTEM**
MONITORING ASSEMBLY FOR AN ELECTRICAL COMPONENT, SEMICONDUCTOR SWITCH ASSEMBLY HAVING A MONITORING FUNCTION, AND ENERGY SYSTEM
ENSEMBLE DE SURVEILLANCE POUR COMPOSANT ÉLECTRIQUE, ENSEMBLE COMMUTATEUR À SEMI-CONDUCTEUR AYANT UNE FONCTION DE SURVEILLANCE, ET SYSTÈME D'ÉNERGIE

(30) Priorität: 11.05.2021 DE 102021204762
(43) Veröffentlichungstag der Anmeldung: 20.03.2024
(73) Patentinhaber: Robert Bosch GmbH, 70442 Stuttgart (DE)
(72) Erfinder: KAUPP, Patrick, 70469 Stuttgart (DE); SCHAEDLICH, Thomas, 70806 Kornwestheim (DE); TZIVANOPOULOS, Chrysanthos, 72663 Grossbettlingen (DE); SWOBODA, Johannes, 70176 Stuttgart (DE); WOLF, Mathis, 70825 Korntal-Muenchingen (DE)
(86) Internationale Anmeldenummer: PCT/EP2022/060800
(87) Internationale Veröffentlichungsnummer: WO 2022/238093

(56) Entgegenhaltungen:
- EP-A1- 3 258 601
- EP-A1- 3 489 707
- WO-A1-2020/216486
- DE-A1- 2 427 785
- US-A1- 2015 198 635

## Beschreibung

### Stand der Technik

Die vorliegende Erfindung betrifft eine Überwachungsanordnung für eine elektrische Komponente, eine Halbleiterschalteranordnung mit einer Überwachungsfunktion und ein Energiesystem mit einer solchen Halbleiterschalteranordnung.

Aus dem Stand der Technik sind Energiesysteme wie elektrische Antriebssysteme elektrisch angetriebener Fahrzeuge bekannt, die beispielsweise eine Traktionsbatterie und einen elektrischen Antriebsmotor umfassen. Zum elektrischen Verbinden und Trennen der Traktionsbatterie vom Antriebsmotor werden beispielsweise elektromechanische Schütze eingesetzt, die mittels einer Diagnosefunktionalität auf Fehlerzustände wie ein Verkleben und/oder ein Verschweißen elektrischer Kontakte überwacht werden. Solche Diagnosefunktionalitäten werden beispielsweise beim Öffnen der Schütze eingesetzt. Wird dabei ein Fehlerzustand festgestellt, ist es dementsprechend möglich, das elektrische Energiesystem mittels einer geeigneten Fehlerreaktion zu schützen.

Zudem ist es bekannt, anstelle von Schützen MOSFETs in einer sogenannten "back-to-back"-Anordnung zu verwenden, um elektrische Energiequellen und elektrische Verbraucher miteinander zu verbinden und zu trennen.

US2015198635 A1 beschreibt eine Vorrichtung zum Messen einer Spannung, welche eine erste Schaltung und eine zweite Schaltung aufweist, wobei die erste Schaltung mit einem oder mehreren Knoten verbunden ist und auf Basis einer Messung ein Anpassungssignal erzeugt und wobei die zweite Schaltung eingerichtet ist, ein Vergleichssignal basierend auf einem Vergleich einer ersten Spannung und einer dritten Spannung zu erzeugen.

Das Dokument WO 2020/216486 A1 offenbart einen Trennschalter mit bidirektionaler Klemmung, der insbesondere in einem Bordnetz eines Kraftfahrzeugs zum Einsatz kommt.

Das Dokument EP 3 489 707 A1 offenbart ein Gerät zur Messung elektrischer Parameter, umfassend einen Spannungstest-Eingangsanschluss, einen gemeinsamen Eingangsanschluss und eine Referenzsignalschaltung.

Das Dokument DE 24 27 785 C2 offenbart eine Schaltungsanordnung für einen Messverstärker.

### Offenbarung der Erfindung

Gemäß einem ersten Aspekt der vorliegenden Erfindung wird eine Überwachungsanordnung für eine elektrische Komponente nach Anspruch 1 vorgeschlagen. Die Überwachungsanordnung weist auf: eine elektrische Komponente, welche beispielsweise einen elektronischen Schalter (z. B. ein Bipolartransistor, ein MOSFET, usw.) und/oder einen elektromechanischen Schalter (z. B. ein Relais, ein Schütz, usw.) und/oder ein Halbleiterbauelement wie eine Diode und/oder einen Messwiderstand und/oder eine elektrische Schaltung usw. umfasst, einen ersten Spannungsteiler mit einem ersten Widerstand und einem zweiten Widerstand, einen zweiten Spannungsteiler mit einem dritten Widerstand und einem vierten Widerstand, einen ersten Schalter, einen zweiten Schalter, welche beispielsweise Halbleiterschalter oder elektromechanische Schalter sind, einen Eingangsanschluss, einen Ausgangsanschluss, einen Bezugspotentialanschluss, welcher beispielsweise ein Masseanschluss der Überwachungsanordnung ist, eine Messeinrichtung, welche beispielsweise ein A/D-Wandler ist und eine Auswerteeinheit, wobei die Auswerteeinheit beispielsweise als ASIC, FPGA, Prozessor, digitaler Signalprozessor, Mikrocontroller, o. ä., ausgestaltet ist.

Die elektrische Komponente ist zwischen den Eingangsanschluss und den Ausgangsanschluss der Überwachungsanordnung geschaltet.

Darüber hinaus ist der erste Spannungsteiler zwischen den Eingangsanschluss und den Bezugspotentialanschluss geschaltet, der zweite Spannungsteiler ist zwischen den Ausgangsanschluss und den Bezugspotentialanschluss geschaltet, der zweite Schalter ist zwischen den Eingangsanschluss und den Ausgangsanschluss geschaltet und der erste Schalter ist zwischen den Eingangsanschluss und einen Verbindungspunkt des ersten Spannungsteilers und des zweiten Schalters geschaltet. Alternativ ist der zweite Schalter zwischen den Ausgangsanschluss und einen Verbindungspunkt des zweiten Spannungsteilers und des zweiten Schalters geschaltet. Weiter alternativ ist es möglich, zusätzlich einen dritten Schalter in dem Pfad anzuordnen, in welchem der zweite Schalter jeweils nicht angeordnet ist.

Ein erster Messanschluss der Messeinrichtung ist mit einem Verbindungspunkt des dritten Widerstandes und des vierten Widerstandes des zweiten Spannungsteilers verbunden, ein zweiter Messanschluss der Messeinrichtung ist mit einem Verbindungspunkt des ersten Widerstandes und des zweiten Widerstandes des ersten Spannungsteilers verbunden und die Messeinrichtung ist eingerichtet, jeweils eine Spannung am ersten Messanschluss und am zweiten Messanschluss zu messen und ein Ergebnis der jeweiligen Messungen an die Auswerteeinheit zu übertragen.

Die Auswerteeinheit ist schließlich eingerichtet, einen Korrekturfaktor für einen Abgleich zwischen dem ersten Spannungsteiler und dem zweiten Spannungsteiler zu ermitteln, während mittels einer Ansteuerung durch die Auswerteeinheit, welche informationstechnisch mit dem ersten Schalter und dem zweiten Schalter verbunden ist, der erste Schalter geöffnet und der zweite Schalter geschlossen ist. Ferner ist die Auswerteeinheit eingerichtet, einen Zustand der elektrischen Komponente auf Basis einer Auswertung einer mittels des Korrekturfaktors korrigierten Spannungsdifferenz zwischen dem ersten Messeingang und dem zweiten Messeingang der Messeinrichtung zu ermitteln, während mittels einer Ansteuerung durch die Auswerteeinheit der erste Schalter geschlossen und der zweite Schalter geöffnet ist.

Die erfindungsgemäße Überwachungsanordnung auf Basis der vorstehend beschriebenen Konfiguration bietet u. a. den Vorteil, dass auf einfache und insbesondere kostengünstige Weise (da z. B. auf teure Instrumentenverstärker und/oder hochpräzise Widerstände verzichtet und/oder eine Kalibrierung während einer Fertigung entfallen kann) präzise Spannungsdifferenzen, insbesondere auch auf höheren Spannungsniveaus (z. B. 48 V oder im Hochvoltbereich) zwischen dem Eingangsanschluss und dem Ausgangsanschluss messbar sind, wodurch eine besonders zuverlässige Überwachung der zu überwachenden elektrischen Komponente ermöglicht wird. Ein weiterer wichtiger Vorteil ergibt sich dadurch, dass die präzise Spannungsmessung im operativen Zustand der elektrischen Komponente bzw. eines die elektrische Komponente einsetzenden übergeordneten Systems erfolgen kann, da insbesondere durch den Betrieb hervorgerufene temperaturbedingte Widerstandänderungen in den beiden Spannungsteilern mittels fortlaufend ermittelter Korrekturfaktoren fortlaufend kompensierbar sind.

Die Unteransprüche zeigen bevorzugte Weiterbildungen der Erfindung.

Bevorzugt sind der erste Spannungsteiler und der zweite Spannungsteiler hinsichtlich ihrer Widerstandswerte symmetrisch aufgebaut, so dass diejenigen Widerstände des ersten Spannungsteilers und des zweiten Spannungsteilers, welche jeweils mit dem Bezugspotentialanschluss verbunden sind, im Wesentlichen dieselben Widerstandswerte aufweisen und die jeweils anderen Widerstände der beiden Spannungsteiler ebenfalls im Wesentlichen dieselben Widerstandswerte aufweisen. "Im Wesentlichen" bedeutet, dass herstellungsbedingte Toleranzen der Widerstandswerte jeweils korrespondierender Widerstände dadurch eingeschlossen sind. Aufgrund der erfindungsgemäßen Korrektur von Abweichungen der Widerstandswerte zwischen den Spannungsteilern ist es zudem vorteilhaft möglich, günstige Widerstände mit höheren Toleranzen einzusetzen, so lange eine Kompensation statischer und/oder dynamischer Abweichungen von Widerstandswerten durch einen vorgegebenen maximalen Messbereich und/oder eine Auflösung der Messeinrichtung nicht maßgeblich beeinträchtigt wird. Alternativ oder zusätzlich ist die Überwachungsanordnung eingerichtet, Spannungen bis zu 60 V, bevorzugt bis zu 400 V und insbesondere bevorzugt bis 800 V zu überwachen.

In einer vorteilhaften Ausgestaltung der vorliegenden Erfindung wird eine Häufigkeit des Ermittelns des Korrekturfaktors und/oder des Messens der mittels des Korrekturfaktors korrigierten Spannungsdifferenz in Abhängigkeit einer Änderungsrate einer zwischen dem Eingangsanschluss und dem Bezugspotentialanschluss gemessenen Spannung und/oder eines zwischen dem Eingangsanschluss und dem Ausgangsanschluss gemessenen Stroms und/oder einer Temperatur im Bereich der elektrischen Komponente und/oder einer Alterung der elektrischen Komponente angepasst. Dies bietet den Vorteil, dass bei einer geringen Änderungsrate vorstehend genannter Größen eine Rechenlast und/oder ein Energieverbrauch in der erfindungsgemäßen Auswerteeinheit gering ist, während sichergestellt ist, dass schnelle Änderungen vorstehender Größen stets mittels einer höheren Messhäufigkeit erfasst werden, so dass durch diese Größen verursachte Abweichungen der Widerstandswerte der beiden Spannungsteiler kompensierbar sind, bevor sich diese Abweichungen negativ auf eine erforderliche bzw. vordefinierte Genauigkeit der Überwachung der beiden Halbleiterschalter auswirken.

In einer weiteren vorteilhaften Ausgestaltung der vorliegenden Erfindung wird im Falle eines ermittelten Fehlerzustandes der elektrischen Komponente mittels der Auswerteeinheit eine Fehlerbehandlung initiiert, welche insbesondere eine elektrische Trennung des Ausgangsanschlusses vom Eingangsanschluss bewirkt. Die Trennung erfolgt - je nach Ausgestaltung der elektrischen Komponente - beispielweise auf Basis der elektrischen Komponente selbst (zumindest mittels eines ggf. noch funktionsfähigen Teils der elektrischen Komponente) und/oder durch eine weitere Trenneinrichtung, welche eingerichtet ist, den Eingangsanschluss und den Ausgangsanschluss unabhängig von der elektrischen Komponente voneinander zu trennen. Alternativ zur Trennung des Eingangsanschlusses vom Ausgangsanschluss ist es auch denkbar, eine am Ausgangsanschluss entnommene Leistung zu reduzieren und/oder ein übergeordnetes System in einen Notlaufmodus zu versetzen sobald ein Fehlerzustand ermittelt wird. Zudem ist es auf Basis der durch die erfindungsgemäße Überwachungsanordnung bereitgestellten präzisen Spannungsmessung möglich, unkritische Fehlerzustände (z. B. Fehlerzustände, die zu keiner kritischen Temperaturerhöhung in der elektrischen Komponente führen) von kritischen Fehlerzuständen innerhalb der elektrischen Komponente zu unterscheiden, so dass entsprechend differenziertere Fehlerreaktionen ausführbar sind.

Bevorzugt erfolgt das Ermitteln des Korrekturfaktors nur dann, wenn ein Strom zwischen dem Eingangsanschluss und dem Ausgangsanschluss einen vordefinierten Stromschwellenwert überschreitet, so dass eine ausreichende Genauigkeit der Messung aufgrund des damit einhergehenden höheren Spannungsabfalls über die elektrische Komponente bzw. der damit einhergehenden höheren Spannungsdifferenz an der Messeinrichtung sichergestellt wird.

In einer weiteren vorteilhaften Ausgestaltung der vorliegenden Erfindung ist zumindest ein Widerstand des ersten Spannungsteilers und/oder zumindest ein Widerstand des zweiten Spannungsteilers außerhalb eines Bereichs angeordnet, in dem eine im Wesentlichen einheitliche Erwärmung der Widerstände der beiden Spannungsteiler aufgrund einer im Wesentlichen einheitlichen Umgebungstemperatur vorliegt. Mit anderen Worten ermöglicht die erfindungsgemäße Überwachungsanordnung eine höhere Anordnungsflexibilität für die Widerstände der beiden Spannungsteiler, da Auswirkungen auf die jeweiligen Widerstandswerte aufgrund von Temperaturunterschieden zwischen den jeweiligen Widerständen durch die (fortlaufende) Kalibrierung insbesondere auch für solche Temperaturunterschiede kompensierbar sind, die im Stand der Technik zu verfälschten Messergebnissen führen würden und welche eine Zuverlässigkeit einer Überwachungsfunktion auf Basis eines nicht erfindungsgemäß kompensierten Spannungsteilers entsprechend reduzieren würden.

Bevorzugt ist die Auswerteeinheit eingerichtet, den ersten Schalter und den zweiten Schalter stets derart anzusteuern, dass über den ersten Schalter und den zweiten Schalter zu keinem Zeitpunkt ein Kurzschluss zwischen dem Eingangsanschluss und dem Ausgangsanschluss erzeugt wird. Dadurch wird insbesondere bei einer Verwendung der erfindungsgemäßen Überwachungsanordnung im Zusammenhang mit höheren Leistungen sichergestellt, dass als Messleitungen (d. h., für geringe Leistungen ausgelegte Leitungen und/oder Leiterbahnen) ausgebildete Verbindungen von und zum ersten und zweiten Schalter, bei einem Kurzschluss über diese Messleitungen und die jeweiligen Schalter, die Messleitungen nicht beschädigt werden. Alternativ oder zusätzlich ist die Auswerteeinheit eingerichtet, im Ansprechen auf ein Ermitteln eines Ruhemodus' eines die Überwachungsanordnung einsetzenden Systems den ersten Schalter zu öffnen. Dadurch ist es möglich einen Stromverbrauch eines die Überwachungsanordnung einsetzenden Systems zu minimieren.

Gemäß einem zweiten Aspekt der vorliegenden Erfindung wird eine Halbleiterschalteranordnung mit Überwachungsfunktion vorgeschlagen, welche eine Überwachungsanordnung nach einem der vorstehenden Ansprüche aufweist. Die elektrische Komponente weist einen ersten Halbleiterschalter mit einer ersten Inversdiode und einen zweiten Halbleiterschalter mit einer zweiten Inversdiode auf, wobei der erste Halbleiterschalter und der zweite Halbleiterschalter bevorzugt MOSFETs, weiter bevorzugt "normal-geschlossene" MOSFETs und insbesondere bevorzugt identisch ausgebildete MOSFETs sind, ohne die Halbleiterschalter dadurch auf vorstehend genannte Ausprägungen einzuschränken. Der erste Halbleiterschalter und der zweite Halbleiterschalter sind derart in Reihe zwischen den Eingangsanschluss und den Ausgangsanschluss geschaltet, dass die erste Inversdiode und die zweite Inversdiode antiseriell geschaltet sind (auch als "back-to-back"-Anordnung bezeichnet). Zudem sind der erste Halbleiterschalter und der zweite Halbleiterschalter eingerichtet, auf Basis einer Ansteuerung einen Stromfluss zwischen dem Eingangsanschluss und dem Ausgangsanschluss zu ermöglichen und zu unterbrechen. Aufgrund der Verwendung von Halbleiterschaltern mit Inversdioden kann sowohl ein unidirektionaler Stromfluss (wenn einer der beiden Halbleiterschalter geöffnet ist, während der jeweils andere geschlossen ist), als auch ein bidirektionaler Stromfluss (wenn beide Halbleiter geöffnet sind) ermöglicht werden. Hinsichtlich der Anordnung der beiden Halbleiterschalter ist sowohl eine Reihenschaltung der beiden Halbleiterschaltern einsetzbar, in welcher die beiden Source-Anschlüsse der beiden Halbleiterschalter miteinander verbunden sind, als auch eine Reihenschaltung, in welcher die beiden Drain-Anschlüsse der beiden Halbleiterschalter miteinander verbunden sind. Eine Ansteuerung des ersten Halbleiterschalters und des zweiten Halbleiterschalters erfolgt beispielsweise mittels der erfindungsgemäßen Auswerteeinheit oder mittels einer separaten Steuereinheit. Die Merkmale, Merkmalskombinationen sowie die sich aus diesen ergebenden Vorteile entsprechen den in Verbindung mit dem erstgenannten Erfindungsaspekt ausgeführten derart ersichtlich, dass zur Vermeidung von Wiederholungen auf die obigen Ausführungen verwiesen wird.

Besonders vorteilhaft schließt das Ermitteln des Zustandes des ersten Halbleiterschalters und/oder des zweiten Halbleiterschalters ein Ermitteln eines im ersten Halbleiterschalter und/oder im zweiten Halbleiterschalter vorliegenden Kurzschlusses und/oder einer Abweichung eines Ist-Schaltzustandes von einem Soll-Schaltzustand des ersten Halbleiterschalters und/oder des zweiten Halbleiterschalters ein. In einem Fall, in dem die Auswerteeinheit selbst eingerichtet, den ersten Halbleiterschalter und den zweiten Halbleiterschalter anzusteuern, verwendet die Auswerteeinheit für das Ermitteln von Abweichungen der jeweiligen Soll-Schaltzustände vorzugsweise interne Statusinformationen, welche die jeweiligen Soll-Schaltzustände repräsentieren. In einem Fall, in dem eine von der Auswerteeinheit abweichende Steuereinheit eingerichtet ist, die beiden Halbleiterschalter anzusteuern, empfängt die Auswerteeinheit die Statusinformationen über die jeweiligen Soll-Schaltzustände vorzugsweise von dieser Steuereinheit.

In einer weiteren vorteilhaften Ausgestaltung der vorliegenden Erfindung ist wenigstens eine weitere Reihenschaltung aus einem dritten Halbleiterschalter und einem vierten Halbleiterschalter parallel zur Reihenschaltung aus dem ersten Halbleiterschalter und dem zweiten Halbleiterschalter geschaltet, so dass beispielsweise höhere Leistungen als mit nur zwei Halbleiterschaltern schaltbar sind.

Gemäß einem dritten Aspekt der vorliegenden Erfindung wird ein Energiesystem vorgeschlagen, welches eine Halbleiterschalteranordnung nach vorstehender Beschreibung, eine Batterie, insbesondere eine Fahrzeugbatterie (z. B. eine Traktionsbatterie), welche zwischen dem Eingangsanschluss und dem Bezugspotentialanschluss angeschlossen ist und einen elektrischen Verbraucher, insbesondere einen elektrischen Verbraucher eines Fahrzeugs (z. B. ein Antriebsmotor) aufweist, der zwischen dem Ausgangsanschluss und dem Bezugspotentialanschluss angeschlossen ist. Auf Basis der erfindungsgemäßen Halbleiterschalteranordnung ist ein solches Energiesystem eingerichtet, die Batterie und den elektrischen Verbraucher zu verbinden und beispielsweise in einem Fehlerzustand oder einem Ruhezustand voneinander zu trennen, während eine zuverlässige Überwachung der Funktionsfähigkeit jeweiliger Halbleiterschalter der Halbleiterschalteranordnung gewährleistet wird. Die Merkmale, Merkmalskombinationen sowie die sich aus diesen ergebenden Vorteile entsprechen den in Verbindung mit dem erst- und zweitgenannten Erfindungsaspekt ausgeführten derart ersichtlich, dass zur Vermeidung von Wiederholungen auf die obigen Ausführungen verwiesen wird.

### Kurze Beschreibung der Zeichnungen

Nachfolgend werden Ausführungsbeispiele der Erfindung unter Bezugnahme auf die begleitende Zeichnung im Detail beschrieben. Dabei zeigen:
- Figur 1: ein Schaltbild einer erfindungsgemäßen Halbleiterschalteranordnung gemäß einer ersten Ausführungsform; und
- Figur 2: ein Schaltbild eines erfindungsgemäßen Energiesystems mit einer erfindungsgemäßen Halbleiterschalteranordnung gemäß einer zweiten Ausführungsform.

### Ausführungsformen der Erfindung

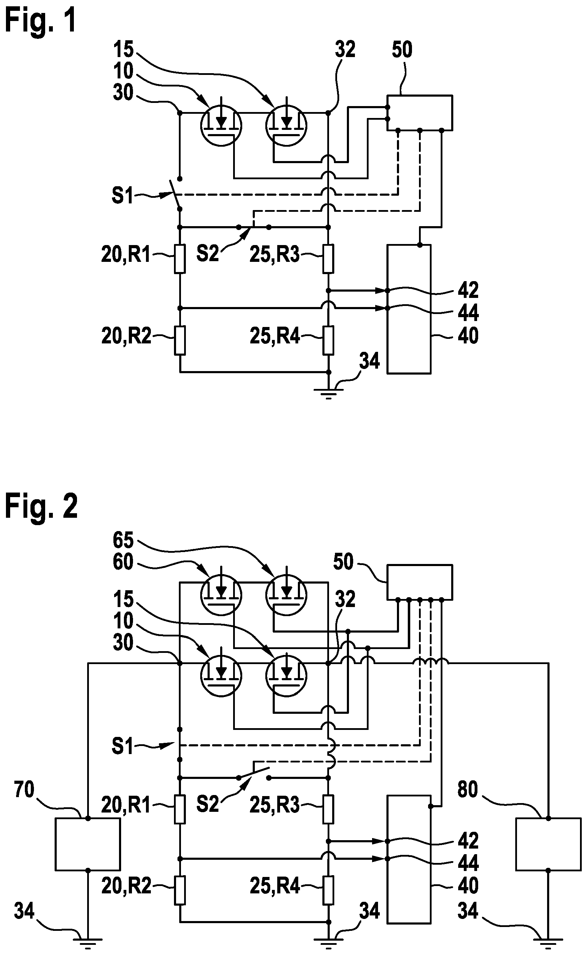

Figur 1 zeigt ein Schaltbild einer erfindungsgemäßen Halbleiterschalteranordnung gemäß einer ersten Ausführungsform, welche auf Basis einer erfindungsgemäßen Überwachungsanordnung ausgebildet ist. Die Halbleiterschalteranordnung weist einen Eingangsanschluss 30, einen Ausgangsanschluss 32 und einen Masseanschluss 34 auf. Zwischen den Eingangsanschluss 30 und den Ausgangsanschluss 32 sind ein erster MOSFET 10 und ein zweiter MOSEFT 15 in einer "back-to-back"-Anordnung vorgesehen. Eine Ansteuerung der beiden MOSFETs 10, 15 erfolgt mittels einer Auswerteeinheit 50, welche elektrisch mit jeweiligen Steuereingängen der beiden MOSFETs 10, 15 verbunden ist. Die Halbleiterschalteranordnung weist zudem einen ersten Spannungsteiler 20, welcher sich aus einem ersten Widerstand R1 und einem zweiten Widerstand R2 zusammensetzt und einen zweiten Spannungsteiler 25 auf, welcher sich aus einem dritten Widerstand R3 und einem vierten Widerstand R4 zusammensetzt. Der Widerstandswert des ersten Widerstandes R1 entspricht im Wesentlichen dem Widerstandswert des dritten Widerstandes R3 und der Widerstandswert des zweiten Widerstandes R2 entspricht im Wesentlichen dem Widerstandswert des vierten Widerstandes R4. In Verbindung mit einer Messeinrichtung, welche hier als A/D-Wandler 40 ausgebildet ist, bilden die beiden Spanungsteiler 20, 25 eine Messbrücke aus. Hierfür ist der A/D-Wandler 40 mittels eines zweiten Messanschlusses 44 mit einem Verbindungspunkt des ersten Widerstandes R1 und des zweiten Widerstandes R2 und mittels eines ersten Messanschlusses 42 mit einem Verbindungspunkt des dritten Widerstandes R3 und des vierten Widerstandes R4 elektrisch verbunden. Darüber hinaus ist der A/D-Wandler 40 informationstechnisch mit der Auswerteeinheit 50 verbunden, so dass die Auswerteeinheit 50 eingerichtet ist, Informationen über jeweilige Spannungsmessungen des A/D-Wandlers 40 am ersten Messanschluss 42 und am zweiten Messanschluss 44 zu empfangen. Darüber hinaus weist die Halbleiterschalteranordnung einen ersten Schalter S1 und einen zweiten Schalter S2 auf, deren jeweilige Steuereingänge informationstechnisch mit der Auswerteeinheit 50 verbunden sind.

Auf Basis der vorstehend beschriebenen Konfiguration ist die Halbleiterschalteranordnung eingerichtet, eine präzise und fortlaufend kalibrierbare Spanungsmessung gemäß vorstehender Beschreibung durchzuführen, so dass auf Basis einer solchen Spannungsmessung eine zuverlässige Überprüfung von Soll-Schaltzuständen und evtl. vorliegenden Kurzschlüssen in den beiden MOSFETs 10, 15 erfolgen kann. Der erste Schalter S1 weist hier beispielhaft einen geöffneten Zustand auf, während der zweite Schalter S2 hier beispielhaft einen geschlossenen Zustand aufweist. Durch diese Zustände liegen die beiden Spanungsteiler 20, 25 folglich auf demselben Potential, so dass ein Abgleich der beiden Spannungsteiler 20, 25 auf Basis jeweiliger Spannungsmessungen durch den A/D-Wandler 40 erfolgen kann.

Im Falle eines ermittelten Fehlerzustandes ist es beispielsweise möglich, eine Trennung des Eingangsanschlusses 30 vom Ausgangsanschluss 32 durch eine Ansteuerung der beiden MOSFETs 10, 15 herbeizuführen.

Zudem ist es möglich, dass ein für die Kalibrierung der Spannungsteiler 20, 25 verwendeter Korrekturfaktor nur dann ermittelt wird, wenn ein vordefinierter Stromschwellenwert durch einen zwischen dem Eingangsanschluss 30 und dem Ausgangsanschluss 32 fließenden Strom überschritten wird.

Ferner ist es möglich, dass zumindest ein Teil der Widerstände R1, R2, R3, R4 örtlich getrennt voneinander angeordnet ist, da unterschiedliche Temperatureinflüsse auf die Widerstände R1, R2, R3 R4 mittels der erfindungsgemäßen Halbleiterschalteranordnung vorteilhaft kompensierbar sind.

Vorzugsweise erfolgt eine Ansteuerung des ersten Schalters S1 und des zweiten Schalters S2 stets derart, dass über den ersten Schalter S1 und den zweiten Schalter S2 zu keinem Zeitpunkt ein Kurzschluss zwischen dem Eingangsanschluss 30 und dem Ausgangsanschluss 32 erzeugt wird und dass im Fall eines vorliegenden Ruhemodus' eines die Halbleiterschalteranordnung einsetzenden Systems der erste Schalter S1 stets geöffnet wird.

Figur 2 zeigt ein Schaltbild eines erfindungsgemäßen Energiesystems mit einer erfindungsgemäßen Halbleiterschalteranordnung gemäß einer zweiten Ausführungsform. Die Halbleiterschalteranordnung in Figur 2 entspricht in weiten Teilen der in Figur 1 beschriebenen Halbleiterschalteranordnung, weshalb zur Vermeidung von Wiederholungen nachfolgend nur die Unterschiede zu Figur 1 beschrieben werden.

In Figur 2 weist die erfindungsgemäße Halbleiterschalteranordnung zusätzlich einen dritten MOSFET 60 und einen vierten MOSFET 65 auf, welche ebenfalls in einer "back-to-back"-Anordnung vorgesehen sind und welche parallel zur Reihenschaltung aus dem ersten MOSFET 10 und dem zweiten MOSFET 15 geschaltet sind. Eine Ansteuerung der MOSFETs 60, 65 erfolgt ebenfalls durch die Auswerteeinheit 50. Dies ermöglicht ein Schalten höherer Leistungen, als in der in Figur 1 gezeigten ersten Ausführungsform der Halbleiterschalteranordnung.

Ferner liegt in Figur 2 beispielhaft ein geschlossener Zustand des ersten Schalters S1 und beispielhaft ein geschlossener Zustand des zweiten Schalters S2 vor, so dass in diesem Zustand ein Ermitteln einer Eingangsspannung zwischen dem Eingangsanschluss 30 und dem Masseanschluss 34 und einer Ausgangsspannung zwischen dem Ausgangsanschluss 32 und dem Masseanschluss 34 auf Basis der abgeglichenen Spannungsteiler 20, 25 bzw. des ermittelten Korrekturfaktors möglich ist.

Das Energiesystem, welches hier ein Energiesystem eines elektrisch antreibbaren Fahrzeugs ist, weist eine Traktionsbatterie 70, die zwischen den Eingangsanschluss 30 und den Masseanschluss 34 geschaltet ist und einen Antriebsmotor 80 auf, der zwischen den Ausgangsanschluss 32 und den Masseanschluss 34 geschaltet ist.

## Patentansprüche

1. Überwachungsanordnung für eine elektrische Komponente aufweisend:
• eine elektrische Komponente (10, 15),
• einen ersten Spannungsteiler (20) mit einem ersten Widerstand (R1) und einem zweiten Widerstand (R2),
• einen zweiten Spannungsteiler (25) mit einem dritten Widerstand (R3) und einem vierten Widerstand (R4),
• einen ersten Schalter (S1),
• einen zweiten Schalter (S2),
• einen Eingangsanschluss (30),
• einen Ausgangsanschluss (32),
• einen Bezugspotentialanschluss (34),
• eine Messeinrichtung (40), und
• eine Auswerteeinheit (50)
wobei
• die elektrische Komponente (10, 15) zwischen den Eingangsanschluss (30) und den Ausgangsanschluss (35) geschaltet ist, der erste Spannungsteiler (20) zwischen den Eingangsanschluss (30) und den Bezugspotentialanschluss (34) geschaltet ist,
• der zweite Spannungsteiler (25) zwischen den Ausgangsanschluss (32) und den Bezugspotentialanschluss (34) geschaltet ist,
• der zweite Schalter (S2) zwischen den Ausgangsanschluss (32) und einen Verbindungspunkt des ersten Schalters (S1) geschaltet ist,
• der erste Schalter (S1)
∘ zwischen den Eingangsanschluss (30) und einen Verbindungspunkt des ersten Spannungsteilers (20) und des zweiten Schalters (S2) geschaltet ist, oder
∘ zwischen den Ausgangsanschluss (32) und einen Verbindungspunkt des zweiten Spannungsteilers (25) und des zweiten Schalters (S2) geschaltet ist,
• ein erster Messanschluss (42) der Messeinrichtung (40) mit einem Verbindungspunkt des dritten Widerstandes (R3) und des vierten Widerstandes (R4) des zweiten Spannungsteilers (25) verbunden ist,
• ein zweiter Messanschluss (44) der Messeinrichtung (40) mit einem Verbindungspunkt des ersten Widerstandes (R1) und des zweiten Widerstandes (R2) des ersten Spannungsteilers (20) verbunden ist,
• die Messeinrichtung (40) eingerichtet ist, jeweils eine Spannung am ersten Messanschluss (42) und am zweiten Messanschluss (44) zu messen und ein Ergebnis der jeweiligen Messungen an die Auswerteeinheit (50) zu übertragen, und
• die Auswerteeinheit (50) eingerichtet ist,
∘ einen Korrekturfaktor für einen Abgleich zwischen dem ersten Spannungsteiler (20) und dem zweiten Spannungsteiler (25) zu ermitteln, während mittels einer Ansteuerung durch die Auswerteeinheit (50) der erste Schalter (S1) geöffnet und der zweite Schalter (S2) geschlossen ist, und
∘ einen Zustand der elektrischen Komponente (10, 15) auf Basis einer Auswertung einer mittels des Korrekturfaktors korrigierten Spannungsdifferenz zwischen dem ersten Messeingang (42) und dem zweiten Messeingang (44) der Messeinrichtung (40) zu ermitteln, während mittels einer Ansteuerung durch die Auswerteeinheit (50) der erste Schalter (S1) geschlossen und der zweite Schalter (S2) geöffnet ist,
wobei eine Häufigkeit des Ermittelns des Korrekturfaktors und/oder des Messens der mittels des Korrekturfaktors korrigierten Spannungsdifferenz in Abhängigkeit
∘ einer Änderungsrate
• einer zwischen dem Eingangsanschluss (30) und dem Bezugspotentialanschluss (34) gemessenen Spannung, und/oder
• eines zwischen dem Eingangsanschluss (30) und dem Ausgangsanschluss (32) gemessenen Stroms, und/oder
• einer Temperatur im Bereich der elektrischen Komponente (10, 15), und/oder
o einer Alterung der elektrischen Komponente (10, 15) angepasst wird.

2. Überwachungsanordnung nach Anspruch 1, wobei
• der erste Spannungsteiler (20) und der zweite Spannungsteiler (25) symmetrisch aufgebaut sind, und/oder
• die Überwachungsanordnung eingerichtet ist, Spannungen bis zu 60 V, bevorzugt bis zu 400 V und insbesondere bevorzugt bis 800 V zu überwachen.

3. Überwachungsanordnung nach einem der vorstehenden Ansprüche, wobei im Falle eines ermittelten Fehlerzustandes der elektrischen Komponente (10, 15) mittels der Auswerteeinheit (50) eine Fehlerbehandlung initiiert wird, welche insbesondere eine elektrische Trennung des Ausgangsanschlusses (32) vom Eingangsanschluss (30) bewirkt.

4. Überwachungsanordnung nach einem der vorstehenden Ansprüche, wobei das Ermitteln des Korrekturfaktors nur dann erfolgt, wenn ein Strom zwischen dem Eingangsanschluss (30) und dem Ausgangsanschluss (32) einen vordefinierten Stromschwellenwert überschreitet.

5. Überwachungsanordnung nach einem der vorstehenden Ansprüche, wobei zumindest ein Widerstand (R1, R2) des ersten Spannungsteilers (20) und/oder zumindest ein Widerstand (R3, R4) des zweiten Spannungsteilers (25) außerhalb eines Bereichs angeordnet ist, in dem eine im Wesentlichen einheitliche Erwärmung der Widerstände der beiden Spannungsteiler (20, 25) aufgrund einer im Wesentlichen einheitlichen Umgebungstemperatur vorliegt.

6. Überwachungsanordnung nach einem der vorstehenden Ansprüche, wobei die Auswerteeinheit (50) eingerichtet ist,
• den ersten Schalter (S1) und den zweiten Schalter (S2) stets derart mittels der Auswerteeinheit (50) [Fig. 1,2] anzusteuern, dass über den ersten Schalter (S1) und den zweiten Schalter (S2) zu keinem Zeitpunkt ein Kurzschluss zwischen dem Eingangsanschluss (30) und dem Ausgangsanschluss (32) erzeugt wird, und/oder
• im Ansprechen auf ein Ermitteln eines Ruhemodus' eines die Überwachungsanordnung einsetzenden Systems den ersten Schalter (S1) zu öffnen.

7. Halbleiterschalteranordnung mit Überwachungsfunktion aufweisend eine Überwachungsanordnung nach einem der vorstehenden Ansprüche, wobei
• die elektrische Komponente einen ersten Halbleiterschalter (10) mit einer ersten Inversdiode und einen zweiten Halbleiterschalter (15) mit einer zweiten Inversdiode aufweist, und
• der erste Halbleiterschalter (10) und der zweite Halbleiterschalter (15)
∘ derart in Reihe zwischen den Eingangsanschluss (30) und den Ausgangsanschluss (32) geschaltet sind, dass die erste Inversdiode und die zweite Inversdiode antiseriell geschaltet sind, und
∘ eingerichtet sind, auf Basis einer Ansteuerung einen Stromfluss zwischen dem Eingangsanschluss (30) und dem Ausgangsanschluss (32) zu ermöglichen und zu unterbrechen.

8. Halbleiterschalteranordnung nach Anspruch 7, wobei das Ermitteln des Zustandes des ersten Halbleiterschalters (10) und/oder des zweiten Halbleiterschalters (15) ein Ermitteln
• eines im ersten Halbleiterschalter (10) und/oder im zweiten Halbleiterschalter (15) vorliegenden Kurzschlusses, und/oder
• einer Abweichung eines Ist-Schaltzustandes von einem Soll-Schaltzustand des ersten Halbleiterschalters (10) und/oder des zweiten Halbleiterschalters (15) einschließt.

9. Halbleiterschalteranordnung nach Anspruch 7 oder 8, wobei wenigstens eine weitere Reihenschaltung aus einem dritten Halbleiterschalter (60) und einem vierten Halbleiterschalter (65) parallel zur Reihenschaltung aus dem ersten Halbleiterschalter (10) und dem zweiten Halbleiterschalter (15) geschaltet ist.

10. Energiesystem aufweisend:
• eine Halbleiterschalteranordnung nach einem Ansprüche 7 bis 9,
• eine Batterie (70), insbesondere eine Fahrzeugbatterie, welche zwischen dem Eingangsanschluss (30) und dem Bezugspotentialanschluss (34) angeschlossen ist, und
• einen elektrischen Verbraucher (80), insbesondere einen elektrischen Verbraucher eines Fahrzeugs, welcher zwischen dem Ausgangsanschluss (32) und dem Bezugspotentialanschluss (34) angeschlossen ist.

## Claims

1. Monitoring arrangement for an electrical component, having:
• an electrical component (10, 15),
• a first voltage divider (20) with a first resistor (R1) and a second resistor (R2),
• a second voltage divider (25) with a third resistor (R3) and a fourth resistor (R4),
• a first switch (S1),
• a second switch (S2),
• an input connection (30),
• an output connection (32),
• a reference potential connection (34),
• a measuring apparatus (40), and
• an evaluation unit (50),
wherein
• the electrical component (10, 15) is connected between the input connection (30) and the output connection (35), the first voltage divider (20) is connected between the input connection (30) and the reference potential connection (34),
• the second voltage divider (25) is connected between the output connection (32) and the reference potential connection (34),
• the second switch (S2) is connected between the output connection (32) and a connecting point of the first switch (S1),
• the first switch (S1)
∘ is connected between the input connection (30) and a connecting point of the first voltage divider (20) and the second switch (S2), or
∘ is connected between the output connection (32) and a connecting point of the second voltage divider (25) and the second switch (S2),
• a first measuring connection (42) of the measuring apparatus (40) is connected to a connecting point of the third resistor (R3) and the fourth resistor (R4) of the second voltage divider (25),
• a second measuring connection (44) of the measuring apparatus (40) is connected to a connecting point of the first resistor (R1) and the second resistor (R2) of the first voltage divider (20),
• the measuring apparatus (40) is configured to measure a respective voltage at the first measuring connection (42) and at the second measuring connection (44) and to transmit a result of the respective measurements to the evaluation unit (50), and
• the evaluation unit (50) is configured
∘ to ascertain a correction factor for an alignment between the first voltage divider (20) and the second voltage divider (25), while the first switch (S1) is opened and the second switch (S2) is closed by means of an actuation by the evaluation unit (50), and
∘ to ascertain a state of the electrical component (10, 15) on the basis of an evaluation of a voltage difference, which is corrected by means of the correction factor, between the first measuring input (42) and the second measuring input (44) of the measuring apparatus (40), while the first switch (S1) is closed and the second switch (S2) is opened by means of an actuation by the evaluation unit (50),
wherein a frequency of ascertaining the correction factor and/or measuring the voltage difference corrected by means of the correction factor is adjusted depending on
∘ a rate of change
• a voltage measured between the input connection (30) and the reference potential connection (34), and/or
• a current measured between the input connection (30) and the output connection (32), and/or
• a temperature in the region of the electrical component (10, 15), and/or
o ageing of the electrical component (10, 15).

2. Monitoring arrangement according to Claim 1, wherein
• the first voltage divider (20) and the second voltage divider (25) are of symmetrical design, and/or
• the monitoring arrangement is configured to monitor voltages up to 60 V, preferably up to 400 V and particularly preferably up to 800 V.

3. Monitoring arrangement according to either of the preceding claims, wherein, if a fault state of the electrical component (10, 15) is ascertained by means of the evaluation unit (50), fault handling is initiated, which in particular causes the output connection (32) to be electrically isolated from the input connection (30).

4. Monitoring arrangement according to one of the preceding claims, wherein the correction factor is ascertained only if a current between the input connection (30) and the output connection (32) exceeds a predefined current threshold value.

5. Monitoring arrangement according to one of the preceding claims, wherein at least one resistor (R1, R2) of the first voltage divider (20) and/or at least one resistor (R3, R4) of the second voltage divider (25) is arranged outside a region in which there is substantially uniform heating of the resistors of the two voltage dividers (20, 25) due to a substantially uniform ambient temperature.

6. Monitoring arrangement according to one of the preceding claims, wherein the evaluation unit (50) is configured
• to continuously actuate the first switch (S1) and the second switch (S2) by means of the evaluation unit (50) [figures 1 and 2] in such a way that a short circuit is not generated between the input connection (30) and the output connection (32) via the first switch (S1) and the second switch (S2) at any time, and/or
• to open the first switch (S1) in response to ascertaining an idle mode of a system using the monitoring arrangement.

7. Semiconductor switch arrangement with a monitoring function, having a monitoring arrangement according to one of the preceding claims, wherein
• the electrical component has a first semiconductor switch (10) with a first inverse diode and a second semiconductor switch (15) with a second inverse diode, and
• the first semiconductor switch (10) and the second semiconductor switch (15)
∘ are connected in series between the input connection (30) and the output connection (32) in such a way that the first inverse diode and the second inverse diode are connected in antiseries, and
∘ are configured to enable and to interrupt a flow of current between the input connection (30) and the output connection (32) on the basis of an actuation.

8. Semiconductor switch arrangement according to Claim 7, wherein ascertaining the state of the first semiconductor switch (10) and/or of the second semiconductor switch (15) includes ascertaining
• a short circuit present in the first semiconductor switch (10) and/or in the second semiconductor switch (15), and/or
• a deviation of an actual switching state from a target switching state of the first semiconductor switch (10) and/or of the second semiconductor switch (15).

9. Semiconductor switch arrangement according to Claim 7 or 8, wherein at least one further series circuit comprising a third semiconductor switch (60) and a fourth semiconductor switch (65) is connected in parallel with the series circuit comprising the first semiconductor switch (10) and the second semiconductor switch (15).

10. Energy system, having:
• a semiconductor switch arrangement according to one of Claims 7 to 9,
• a battery (70), in particular a vehicle battery, which is connected between the input connection (30) and the reference potential connection (34), and
• an electrical load (80), in particular an electrical load of a vehicle, which is connected between the output connection (32) and the reference potential connection (34).

## Revendications

1. Ensemble de surveillance pour un composant électrique, comportant :
• un composant électrique (10, 15),
• un premier diviseur de tension (20) avec une première résistance (R1) et une deuxième résistance (R2),
• un deuxième diviseur de tension (25) avec une troisième résistance (R3) et une quatrième résistance (R4),
• un premier interrupteur (S1),
• un deuxième interrupteur (S2),
• une borne d'entrée (30),
• une borne de sortie (32),
• une borne de potentiel de référence (34),
• un dispositif de mesure (40), et
• une unité d'évaluation (50),
• le composant électrique (10, 15) étant branché entre la borne d'entrée (30) et la borne de sortie (35), le premier diviseur de tension (20) étant branché entre la borne d'entrée (30) et la borne de potentiel de référence (34),
• le deuxième diviseur de tension (25) étant branché entre la borne de sortie (32) et la borne de potentiel de référence (34),
• le deuxième commutateur (S2) étant branché entre la borne de sortie (32) et un point de raccordement du premier commutateur (S1),
• le premier interrupteur (S1)
∘ étant branché entre la borne d'entrée (30) et un point de raccordement du premier diviseur de tension (20) et du deuxième commutateur (S2), ou
∘ étant branché entre la borne de sortie (32) et un point de raccordement du deuxième diviseur de tension (25) et du deuxième commutateur (S2),
• une première borne de mesure (42) du dispositif de mesure (40) étant raccordée à un point de raccordement de la troisième résistance (R3) et de la quatrième résistance (R4) du deuxième diviseur de tension (25),
• une deuxième borne de mesure (44) du dispositif de mesure (40) étant raccordée à un point de raccordement de la première résistance (R1) et de la deuxième résistance (R2) du premier diviseur de tension (20),
• le dispositif de mesure (40) étant mis au point pour mesurer respectivement une tension sur la première borne de mesure (42) et sur la deuxième borne de mesure (44) et pour transmettre un résultat des mesures respectives à l'unité d'évaluation (50), et
• l'unité d'évaluation (50) étant mise au point pour
∘ déterminer un facteur de correction pour une comparaison entre le premier diviseur de tension (20) et le deuxième diviseur de tension (25), le premier commutateur (S1) étant ouvert et le deuxième commutateur (S2) étant fermé au moyen d'un pilotage par l'unité d'évaluation (50), et
∘ déterminer un état du composant électrique (10, 15) sur la base d'une évaluation d'une différence de tension, corrigée au moyen du facteur de correction, entre la première entrée de mesure (42) et la deuxième entrée de mesure (44) du dispositif de mesure (40), tandis que le premier commutateur (S1) est fermé et le deuxième commutateur (S2) est ouvert au moyen d'un pilotage de l'unité d'évaluation (50),
une fréquence de la détermination du facteur de correction et/ou de la mesure de la différence de tension corrigée au moyen du facteur de correction étant adaptée en fonction
∘ d'un taux de changement
• d'une tension mesurée entre la borne d'entrée (30) et la borne de potentiel de référence (34), et/ou
• d'un courant mesuré entre la borne d'entrée (30) et la borne de sortie (32), et/ou
• d'une température dans la zone du composant électrique (10, 15), et/ou
o d'un vieillissement du composant électrique (10, 15).

2. Ensemble de surveillance selon la revendication 1,
• le premier diviseur de tension (20) et le deuxième diviseur de tension (25) étant de structure symétrique, et/ou
• l'ensemble de surveillance étant mis au point pour surveiller des tensions allant jusqu'à 60 V, de manière préférée jusqu'à 400 V et de manière particulièrement préférée jusqu'à 800 V.

3. Ensemble de surveillance selon l'une des revendications précédentes, **caractérisé en ce que** dans le cas d'un état de défaut déterminé du composant électrique (10, 15), un traitement de défaut est lancé au moyen de l'unité d'évaluation (50), lequel traitement de défaut provoque en particulier une coupure électrique de la borne de sortie (32) de la borne d'entrée (30).

4. Ensemble de surveillance selon l'une des revendications précédentes, le facteur de correction étant déterminé seulement lorsqu'un courant entre la borne d'entrée (30) et la borne de sortie (32) dépasse une valeur seuil de courant prédéfinie.

5. Ensemble de surveillance selon l'une des revendications précédentes, au moins une résistance (R1, R2) du premier diviseur de tension (20) et/ou au moins une résistance (R3, R4) du deuxième diviseur de tension (25) étant disposées en dehors d'une zone dans laquelle un chauffage sensiblement uniforme des résistances des deux diviseurs de tension (20, 25) est réalisé en raison d'une température ambiante sensiblement uniforme.

6. Ensemble de surveillance selon l'une des revendications précédentes, l'unité d'évaluation (50) étant mise au point pour
• toujours piloter le premier commutateur (S1) et le deuxième commutateur (S2) au moyen de l'unité d'évaluation (50) [figures 1, 2] de telle manière qu'un court-circuit entre la borne d'entrée (30) et la borne de sortie (32) ne soit produit à aucun moment par le premier commutateur (S1) et le deuxième commutateur (S2), et/ou
• ouvrir le premier commutateur (S1) en réponse à une détermination d'un mode veille d'un système utilisant l'ensemble de surveillance.

7. Ensemble de commutateur à semi-conducteur avec une fonction de surveillance, comportant un ensemble de surveillance selon l'une des revendications précédentes,
• le composant électrique comportant un premier commutateur à semi-conducteur (10) avec une première diode inverse et un deuxième commutateur à semi-conducteur (15) avec une deuxième diode inverse, et
• le premier commutateur à semi-conducteur (10) et le deuxième commutateur à semi-conducteur (15)
∘ étant branchés en série entre la borne d'entrée (30) et la borne de sortie (32) de telle manière que la première diode inverse et la deuxième diode inverse sont branchées en antisérie, et
∘ étant mis au point pour permettre et interrompre un flux de courant entre la borne d'entrée (30) et la borne de sortie (32) sur la base d'un pilotage.

8. Ensemble de commutateur à semi-conducteur selon la revendication 7, la détermination de l'état du premier commutateur à semi-conducteur (10) et/ou du deuxième commutateur à semi-conducteur (15) incluant une détermination
• d'un court-circuit présent dans le premier commutateur à semi-conducteur (10) et/ou dans le deuxième commutateur à semi-conducteur (15), et/ou
• d'un écart d'un état de commutation réel par rapport à un état de commutation de consigne du premier commutateur à semi-conducteur (10) et/ou du deuxième commutateur à semi-conducteur (15).

9. Ensemble de commutateur à semi-conducteur selon la revendication 7 ou 8, au moins un autre circuit série composé d'un troisième commutateur à semi-conducteur (60) et d'un quatrième commutateur à semi-conducteur (65) étant branché en parallèle du circuit série composé du premier commutateur à semi-conducteur (10) et du deuxième commutateur à semi-conducteur (15).

10. Système énergétique comportant :
• un ensemble de commutateur à semi-conducteur selon l'une des revendications 7 à 9,
• une batterie (70), en particulier une batterie de véhicule, qui est connectée entre la borne d'entrée (30) et la borne de potentiel de référence (34), et
• un consommateur électrique (80), en particulier un consommateur électrique d'un véhicule, qui est connecté entre la borne de sortie (32) et la borne de potentiel de référence (34).
